# EUROPÄISCHE PATENTSCHRIFT

(11) **EP 3 109 097 B1**
(45) Veröffentlichungstag und Bekanntmachung des Hinweises auf die Patenterteilung: **29.08.2018**
(21) Anmeldenummer: 15306012.4
(22) Anmeldetag: 26.06.2015
(51) Int. Cl.: B60R 16/02, H02G 3/04

(54) **VORRICHTUNG ZUR AUFNAHME EINES KABELSTRANGS**
DEVICE FOR HOLDING A WIRING HARNESS
DISPOSITIF DE RECEPTION D'UN FAISCEAU DE CABLES

(43) Veröffentlichungstag der Anmeldung: 28.12.2016
(73) Patentinhaber: Nexans, 92400 Courbevoie (FR)
(72) Erfinder: KREUZER, Thomas, 92660 Neustadt a.d. Waldnaab (DE); WALTER, Erhard, 92697 Georgenberg (DE)
(74) Vertreter: Lenne, Laurence

(56) Entgegenhaltungen:
- EP-A1- 1 312 511
- WO-A1-01/28057
- WO-A1-2015/080024
- DE-B4-102007 035 539
- US-A- 4 248 459
- US-A1- 2007 084 619

## Beschreibung

Die Erfindung bezieht sich auf eine Vorrichtung zur Aufnahme mindestens eines Kabelstrangs gemäß dem Oberbegriff des Patentanspruchs 1.

Eine solche Vorrichtung geht beispielsweise aus der DE 10 2007 035 539 B4 hervor.

Das Gehäuse einer derartigen Vorrichtung ist beispielsweise ein in der Fahrzeugtechnik üblicher Kabelkanal zur Aufnahme eines aus vielen elektrischen Leitern bestehenden Kabelstrangs bzw. Kabelbaums. Ein Gehäuse kann aber auch ein Schaltergehäuse oder eine Verbindungsmuffe oder eine andere Vorrichtung sein, an die in einem gewellten Rohr angeordnete, elektrische Leiter angeschlossen und dazu einschließlich des Rohres in das Gehäuse eingeführt werden. Ein solches, in der Regel aus einem Oberteil und einem Unterteil bestehendes Gehäuse wird beispielsweise durch Spritzgießen hergestellt, wobei für das Anschließen von gewellten Rohren geeignete Öffnungen vorgesehen sind.

Die D1 EP 1 312 511 A1 beschreibt ein Gehäuse, das aus zwei länglichen, in Längsrichtung geteilten und mittels einer Vielzahl von einrastenden Elementen zusammenfügbaren Teilen besteht. Im zusammengefügten Zustand hat das Gehäuse ein zentrales, in Längsrichtung verlaufendes Durchgangsloch, durch das ein Kabelstrang geführt werden kann. In dem Gehäuse ist ein rohrförmiger, axial kurzer Rotationskörper angebracht, der um seine Achse, die mit der Längsachse des Gehäuses übereinstimmt, drehbar gelagert ist. Er besteht ebenfalls aus zwei in Längsrichtung getrennten und zusammenfügbaren Teilen. Die beiden Teile des Rotationskörpers haben an ihren inneren Oberflächen Rippen, die im Montagezustand in ein ringförmig gewelltes Rohr eingreifen, das in dem Gehäuse angebracht ist und durch welches der Kabelstrang hindurchgeführt ist.

Aus der eingangs erwähnten DE 10 2007 035 539 B4 geht ein Gehäuse aus Kunststoff zur Aufnahme mindestens eines Kabelstrangs hervor, welches aus zwei entlang einer

Trennebene getrennten Teilen besteht. Das Gehäuse weist einen rohrförmigen, ebenfalls entlang der Trennebene in zwei Teile geteilten Stutzen zur Befestigung eines ringförmig gewellten Rohres aus Kunststoff auf, das zur Aufnahme von elektrischen Leitungen dient. Die Trennebene und die Achse des aus einem beweglichen Teil und einem fest mit dem zugehörigen Teil des Gehäuses verbundenen starren Teil bestehenden Stutzens verlaufen unter einem spitzen Winkel zur Trennebene des Gehäuses.

Der Erfindung liegt die Aufgabe zugrunde, den Aufbau der eingangs geschilderten Vorrichtung zu vereinfachen.

Diese Aufgabe wird entsprechend den kennzeichnenden Merkmalen des Patentanspruchs 1 gelöst.

Das Gehäuse dieser Vorrichtung besteht vorzugsweise aus zwei Teilen, einem Oberteil bzw. Deckel und einem Unterteil, die in Montageposition zu einem einteiligen Gehäuse miteinander verbunden sind. Bei der Herstellung der beiden Teile des Gehäuses wird mit Vorteil in der Wandung des Unterteils mindestens eine Öffnung erzeugt, die an der Oberkante des Unterteils offen ist. Die Öffnung hat vorzugsweise einen rechteckigen Querschnitt. Für die Festlegung eines ringförmig gewellten Rohres am Gehäuse wird ein Halter eingesetzt, der als fertiger Halter einen Durchlaß für das Rohr aufweist. Die Größe und Form der Öffnung im Unterteil des Gehäuses sind unabhängig vom Durchmesser eines darin zu befestigenden gewellten Rohres. Die Fertigung des Gehäuses insgesamt kann dadurch wesentlich vereinfacht werden und das Gehäuse ist für gewellte Rohre mit unterschiedlichen Durchmessern verwendbar. Es muß nur jeweils ein passender Halter in die Öffnung eingesetzt werden. Seine Teile werden jeweils in der die Öffnung begrenzenden Wandung des Unterteils geführt.

Wenn zwei gewellte Rohre nebeneinander in nur einer Öffnung des Gehäuses angebracht werden sollen, kann der Halter mit Vorteil aus drei miteinander zu verbindenden Teilen bestehen. Ein mittlerer Teil des Halters hat dann auf zwei einander gegenüberliegenden Seiten je eine Hälfte eines Durchlasses, der jeweils von den beiden äußeren Teilen des Halters zu zwei vollständigen Durchlässen zur Aufnahme von zwei gewellten Rohren ergänzt wird.

Ausführungsbeispiele des Erfindungsgegenstandes sind in den Zeichnungen dargestellt.

Es zeigen:
Fig. 1 in schematischer Darstellung ein Gehäuse für eine Vorrichtung nach der Erfindung.
Fig. 2 eine Seitenansicht des Gehäuses nach Fig. 1 ebenfalls in schematischer Darstellung.
Fig. 3 eine Öffnung des Gehäuses der Vorrichtung.
Fig. 4 einen in die Öffnung nach Fig. 3 einsetzbaren Halter.
Fig. 5 und 6 einen in eine Öffnung nach Fig. 3 eingesetzten Halter.
Fig. 7 und 8 zwei unterschiedliche, gegenüber Fig. 4 ergänzten Halter.

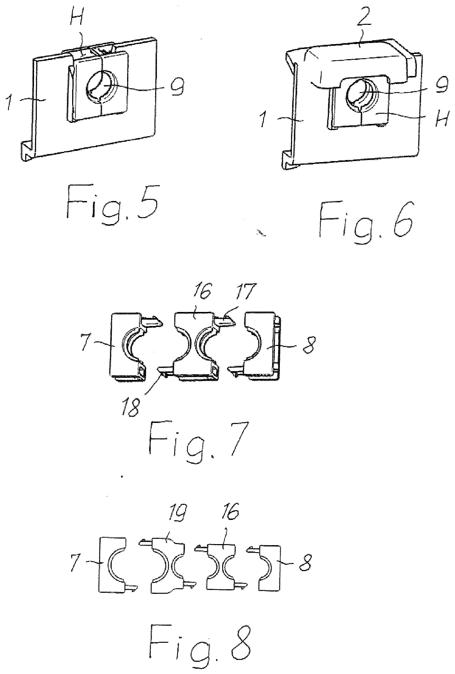

Der Einfachheit und Deutlichkeit halber ist das im Gehäuse der Vorrichtung zu befestigende gewellte Rohr in den Fig. 5 und 6 nicht mit dargestellt.

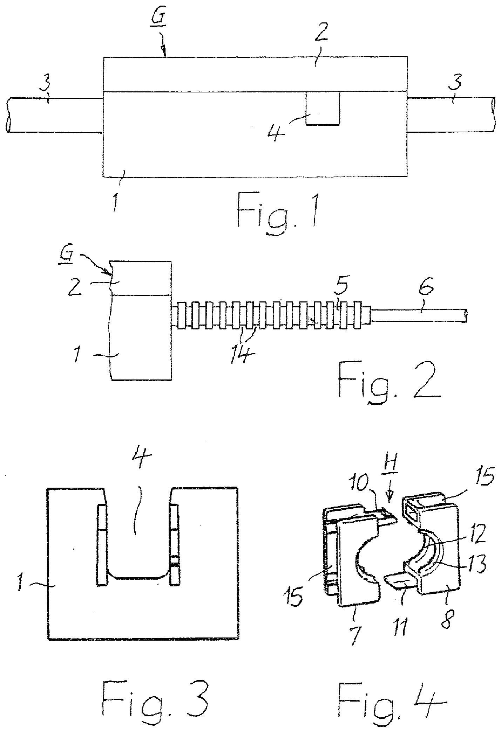

In Fig. 1 ist schematisch ein aus einem Unterteil 1 und einem Oberteil 2 bestehendes Gehäuse G dargestellt, das zur Aufnahme und zum Durchführen bzw. Aufteilen eines eine Vielzahl von Leitungen enthaltenden Kabelstrangs 3 dient. Das Gehäuse G besteht aus Kunststoff, wie beispielsweise Polypropylen oder Polyamid. Das Unterteil 1 ist vorzugsweise in Form einer Wanne ausgeführt und das Oberteil 2 ist vorzugsweise ein Deckel, der bei geschlossenem Gehäuse G auf das Unterteil 1 aufgesetzt und mit demselben verbunden ist.

Im Unterteil 1 des Gehäuses G ist eine Öffnung 4 angebracht, in der in Montageposition ein ebenfalls aus Kunststoff, wie beispielsweise Polypropylen oder Polyamid, bestehendes Rohr 5 befestigt ist, das ringförmig gewellt ist. In dem Rohr 5 ist ein Kabelstrang 6 aufgenommen, der in das Gehäuse G hineingeführt ist. Die Öffnung 4 des Unterteils 1 hat gemäß Fig. 3 mit Vorteil einen rechteckigen lichten Querschnitt. Sie ragt bis zur Oberkante des Unterteils 1 und ist nach außen offen.

Zur Befestigung des Rohres 5 in der Öffnung 4 kann ein in Fig. 4 dargestellter, aus zwei Teilen 7 und 8 bestehender Halter H verwendet werden, der einen Durchlaß 9 (Fig. 5) zur

Aufnahme des Rohres 5 hat. Der in Fig. 5 gezeigte Halter H ist dann fertiggestellt, wenn seine beiden Teile 7 und 8 zusammengefügt sind. Sie können dazu vorzugsweise mit einrastenden Elementen 10 und 11 ausgerüstet sein. In jedem der beiden Teile 7 und 8 ist eine Hälfte des Durchlasses 9 ausgeformt, so daß sich bei zusammengefügten Teilen 7 und 8 der rundum geschlossene Durchlaß 9 ergibt.

Die Teile 7 und 8 des Halters H haben auf ihren gebogen verlaufenden, den Durchlaß 9 begrenzenden Seiten im dargestellten Ausführungsbeispiel zwei sich - bezogen auf ein umschlossenes Rohr 5 - in Umfangsrichtung erstreckende, mit Abstand parallel zueinander verlaufenden Rippen 12 und 13. Sie sind in Fig. 4 wegen der perspektivischen Darstellung nur am Teile 8 zu erkennen. Die Rippen 12 und 13 greifen im Montagezustand in zwei benachbarte Wellentäler 14 (Fig. 2) des gewellten Rohres 5 ein. Der Halter H soll mindestens eine derartige Rippe haben. Es können auch mehr als zwei parallel zueinander verlaufende Rippen sein. Die Teile 7 und 8 des Halters H haben an ihren Außenkanten durchgehend nutförmige Vertiefungen 15, deren lichte Weite der Dicke der Wandung des Unterteils 1 des Gehäuses G entspricht.

Wenn der Halter H nach fertiger Montage um ein gewelltes Rohr 5 herumgelegt und in der Öffnung 4 angebracht ist, kann gemäß Fig. 6 das Oberteil 2 des Gehäuses G auf das Unterteil 1 aufgesetzt werden. Der Halter H und das von ihm umschlossene gewellte Rohr 5 sind dann im Gehäuse G festgelegt.

Zur Befestigung des Rohres 5 am bzw. im Gehäuse G wird beispielsweise wie folgt vorgegangen:
Die beiden Teile 7 und 8 des Halters H werden am Ende des ringförmig gewellten Rohres 5 von zwei einander gegenüberliegenden Seiten her an das Rohr angelegt und so weit aufeinander zu bewegt, bis sie durch ihre einrastenden Elemente 10 und 11 miteinander verbunden sind. In dieser Position greifen die Rippen 12 und 13 der Teile 7 und 8 in zwei nebeneinander liegende Wellentäler 14 des Rohres 5 ein. Der fertige Halter H kann dann zusammen mit dem umschlossenen Rohr 5 in die Öffnung 4 des Unterteils 1 des Gehäuses G eingesetzt werden. Dabei wird der Halter H durch seine nutförmigen Vertiefungen 15 von der die Öffnung 4 begrenzenden Wandung des Unterteils 1 des Gehäuses G geführt.

Die Endposition des Halters H geht aus Fig. 5 hervor. Abschließend kann das Oberteil 2 auf das Unterteil 1 des Gehäuses G aufgesetzt werden, so wie es in Fig. 6 dargestellt ist. Das Rohr 5 kann vor seiner Montage auf den Kabelstrang 6 aufgeschoben sein.

Alternativ zu der beschriebenen Montage des Halters H könnte auch zunächst der Teil 7 des Halters H so in die Öffnung 4 im Unterteil 1 des Gehäuses G eingesetzt werden, daß seine gebogen verlaufende Seite nach oben weist. Beim Einsetzen wird der Teil 7 von der Wandung des Unterteils 1 geführt, die in die nutförmigen Vertiefungen 15 desselben eingreift. Danach könnte das Rohr 5 mit seinem einen Ende auf den Teil 7 so aufgelegt werden, daß die Rippen 12 und 13 in zwei Wellentäler 14 des Rohres 5 eingreifen. Anschließend würde dann der Teil 8 des Halters H in die Öffnung 4 des Unterteils 1 eingesetzt und durch die Wandung desselben geführt so weit nach unten verschoben werden, bis seine Rippen 12 und 13 in die gleichen Wellentäler 14 des Rohres 5 wie die des Teils 7 eingreifen. In der Endposition wären die beiden Teile 7 und 8 durch die federnd einrastenden Elemente 10 und 11 zu dem Halter H miteinander verbunden. Dessen Endposition geht auch dann aus Fig. 5 hervor.

Wenn in einer Öffnung 4 des Gehäuses zwei ringförmig gewellte Rohre 5 angeordnet werden sollen, kann ein entsprechend ergänzter, in Fig. 7 dargestellter Halter H verwendet werden, der in eine dazu passende größere Öffnung 4 eingesetzt werden kann. Dieser Halter H besteht aus den Teilen 7 und 8 und einem Zwischenteil 16, der in Montageposition mit den beiden Teilen 7 und 8 verbunden ist. Das kann wieder mittels einrastender Elemente 17 und 18 erfolgen. Zwischen den drei Teilen 7, 8 und 16 dieses Halters H sind in Montageposition zwei Durchlässe 9 vorhanden.

Ein weiter ergänzter Halter H, der zum Festlegen von drei Rohren in einer entsprechend großen Öffnung im Unterteil 1 des Gehäuses G verwendet werden kann, geht aus Fig. 8 hervor. Dieser Halter H hat ein zweites Zwischenteil 19, das im Aufbau dem Zwischenteil 16 nach Fig. 7 entspricht.

## Patentansprüche

1. Vorrichtung zur Aufnahme mindestens eines Kabelstrangs, welche ein durch Wandungen begrenztes Gehäuse (G) aus mechanisch stabilem Isoliermaterial zur Aufnahme mindestens eines Kabelstrangs aufweist, an das mindestens ein ringförmig gewelltes Rohr (5) aus Kunststoff angeschlossen ist, das in Montageposition in einer Öffnung (4) des Gehäuses (G) befestigt ist und einen Kabelstrang (6) umschließt, **dadurch gekennzeichnet,**
- **dass** das Gehäuse (G) aus einem Oberteil (2) und aus einem Unterteil (1) besteht, die in Montageposition zu einem einteiligen Gehäuse miteinander verbunden sind,
- **dass** die Öffnung (4) des Gehäuses (G) in der Wandung des Unterteils (1) angebracht und an der Oberkante desselben nach außen offen ist,
- **dass** in der Öffnung (4) des Gehäuses (G) ein in Montageposition in der Wandung desselben geführter, aus zusammenfügbaren Teilen bestehender Halter (H) angebracht ist, bei dem jeweils zwei Teile (7,8) im zusammengefügten Zustand einen den Abmessungen des in der Öffnung (4) des Gehäuses (G) zu befestigenden, ringförmig gewellten Rohres (5) entsprechenden zentralen Durchlaß (9) zwischen sich einschließen, und
- **dass** jeweils zwei Teile (7,8) des Halters (H) in Montageposition auf zwei einander diametral gegenüber liegenden Seiten des Rohres (5) in mindestens ein Wellental (14) der ringförmigen Wellung desselben eingreifen.

2. Vorrichtung nach Anspruch 1, **dadurch gekennzeichnet, dass** die Teile (7,8) des Halters (H) in Montageposition durch einrastende Elemente (10,11) lösbar miteinander verbunden sind.

3. Vorrichtung nach Anspruch 1 oder 2, **dadurch gekennzeichnet, dass** die Teile (7,8) des Halters (H) mindestens eine Rippe (12,13) aufweisen, welche in Montageposition in ein Wellental (14) des ringförmig gewellten Rohres (5) eingreift.

4. Vorrichtung nach Anspruch 1, **dadurch gekennzeichnet, dass** zur Befestigung von zwei oder mehr nebeneinander liegenden, ringförmig gewellten Rohren in einer Öffnung (4) des Gehäuses (G) ein aus mindestens drei zusammenfügbaren Teilen (7,8,16) bestehender Halter eingesetzt ist.

## Claims

1. A device for holding at least one wiring harness, which has a housing (G) bounded by walls made from mechanically stable insulating material for holding at least one wiring harness, to which at least one annularly corrugated tube (5) made of plastic is connected, which is fastened in the mounting position in an opening (4) of the housing (G) and encloses a wiring harness (6), **characterized in**
- **that** the housing (G) consists of an upper part (2) and of a lower part (1), which are connected with each other in the mounting position to form a one-piece housing,
- **that** the opening (4) of the housing (G) is arranged in the wall of the lower part (1) and is open on the upper edge of the same towards the outside,
- **that** in the opening (4) of the housing (G) a holder (H) is arranged guided in the mounting position in the wall of the same and consisting of interconnectable parts, in which in each case two parts (7, 8) in the interconnected state enclose between them a central through-passage (9) corresponding to the dimensions of the annularly corrugated tube (5) to be fastened in the opening (4) of the housing (G), and
- **that** in each case two parts (7, 8) of the holder (H) in the mounting position engage on two diametrically opposite sides of the tube (5) in at least one trough (14) of the annular corrugation of the same.

2. A device according to Claim 1, **characterized in that** the parts (7, 8) of the holder (H) are connected detachably to each other in the mounting position by latching elements (10, 11).

3. A device according to Claim 1 or 2, **characterized in that** the parts (7, 8) of the holder (H) have at least one rib (12, 13), which in the mounting position engages in a trough (14) of the annularly corrugated tube (5).

4. A device according to Claim 1, **characterized in that** in order to fasten two or more adjacent, annularly corrugated tubes in an opening (4) of the housing (G) a holder consisting at least of three interconnectable parts (7, 8, 16) is used.

## Revendications

1. Dispositif de logement d'au moins un faisceau de câbles, qui comprend un boîtier (G) délimité par des parois en matériau isolant mécaniquement robuste, pour le logement d'au moins un faisceau de câbles, auquel est raccordé à au moins un tube (5) ondulé de manière annulaire en matière plastique, qui est fixé, en position de montage, dans une ouverture (4) du boîtier (G), et entoure un faisceau de câbles (6), **caractérisé en ce que**
- le boîtier (G) est constitué d'une partie supérieure (2) et d'une partie inférieure (1), qui sont reliées entre elles, en position de montage, afin d'obtenir d'un boîtier d'une seule pièce,
- l'ouverture (4) du boîtier (G) est réalisée dans la paroi de la partie inférieure (1) et est ouverte vers l'extérieur au niveau de l'arête supérieure de celui-ci,
- dans l'ouverture (4) du boîtier (G), est monté un support (H), guidé dans la paroi de celui-ci et constitué de parties pouvant être assemblées, dans lequel deux parties (7, 8) forment entre elles, dans l'état assemblé, un passage central (9) correspondant aux dimensions du tube (5) ondulé de manière annulaire à fixer dans l'ouverture (4) du boitier (G) et
- deux parties (7, 8) du support (H) s'emboîtent, dans la position de montage, sur deux côtés diamétralement opposés du tube (5) dans au moins un creux (14) de l'ondulation annulaire de celui-ci.

2. Dispositif selon la revendication 1, **caractérisé en ce que** les parties (7, 8) du support (H) sont reliées de manière amovible entre elles, en position de montage, par des éléments d'encliquetage (10, 11).

3. Dispositif selon la revendication 1 ou 2, **caractérisé en ce que** les parties (7, 8) du support (H) comprennent au moins une nervure (12, 13), qui s'emboîte, en position de montage, dans un creux (14) du tube (5) ondulé de manière ondulée.

4. Dispositif selon la revendication 1, **caractérisé en ce que**, pour la fixation de deux tubes ondulés de manière annulaire, juxtaposés, est inséré, dans une ouverture (4) du boîtier (G), un support constitué de trois parties (7, 8, 16) pouvant être assemblées.
